# EUROPEAN PATENT APPLICATION

(11) **EP 3 479 931 A1**
(43) Date of publication of application: **08.05.2019**
(21) Application number: 18195750.7
(22) Date of filing: 20.09.2018
(51) Int. Cl.: B22F 1/00, B22F 9/04, B22F 9/06, B22F 9/12, C22C 1/04, C22C 9/00, H01L 31/032, H01L 31/0749, B22F 7/04

(54) **MULTI-ELEMENT ALLOY COMPOUND, INK AND FILM ABSORPTION LAYER THEREOF, AND METHODS FOR PREPARING THE SAME**

(30) Priority: 06.11.2017 CN 201711079613
(71) Applicant: Beijing Apollo Ding Rong Solar Technology Co., Ltd., Beijing 100176 (CN)
(72) Inventor: CHEN, Teng, Beijing, 100176 (CN)
(74) Representative: D'Halleweyn, Nele Veerle Trees Gertrudis

(57) **Abstract**

A method for preparing a multi-element alloy compound is provided. The method includes the following steps: placing materials to be melted in a high-temperature synthesis zone of a vacuum container after being uniformly mixed, and placing materials to be sublimated in a low-temperature evaporation zone of the vacuum container; heating the materials to be melted in the high-temperature synthesis zone to a molten state to form a molten material; heating the materials to be sublimated in the low-temperature evaporation zone to a gaseous state to allow the sublimated gaseous material to react with the molten material. The prepared multi-element alloy compound, a method for preparing ink by adopting the multi-element alloy compound and the prepared multi-element alloy compound ink, as well as a method for preparing a film absorption layer by adopting the multi-element alloy compound ink and the prepared multi-element alloy compound film absorption layer are provided.

## Description

### Technical Field

The present disclosure relates to, but is not limited to, a method for preparing a multi-element alloy compound and the prepared multi-element alloy compound, a method for preparing ink by adopting the multi-element alloy compound and the prepared multi-element alloy compound ink, as well as a method for preparing a film absorption layer by adopting the multi-element alloy compound ink and the prepared multi-element alloy compound film absorption layer.

### Background

As is well-known, CIGS (CuInₓGa₍₁₋ₓ₎Se₂, copper indium gallium selenium) is a kind of thin film solar cell with great potential. At present, the main methods for preparing CIGS in the industry are co-evaporation method and magnetron sputtering method. Based on the high vacuum of these two previous methods, the cost is relatively high from the point of view of equipment and process. Therefore, non-vacuum and low-cost technology for preparing CIGS such as printing is continuously promoted by the industry.

At present, there are two main methods for preparing coating slurry or colloid used for non-vacuum printing CIGS. One is that CIGS nano-materials are prepared by chemical synthesis method and further prepared into the slurry. However, the chemically synthesized CIGS has low purity, and the minority carrier lifetime of the prepared CIGS thin film is short, so the current battery using this kind of absorption layer has relatively low efficiency. The other is that four elemental powders or several binary, ternary compound powders are used to prepare the coating raw materials. It is difficult to control the reaction of this slurry to further form a quaternary compound during the film forming process, and insufficient reaction will cause the compositions to be mismatched. Moreover, the higher reaction temperature may also cause a large amount of loss of selenium component, resulting in poor quality of the prepared CIGS thin film.

In addition, the preparation of CIGS thin films with gradient band gaps is beneficial to improve the conversion efficiency of the thin film light absorption layer. However, limited to the preparation method of CIGS materials, most of the current prepared by printing are CIGS thin films with a single fixed composition, which is not conducive to the preparation of high efficiency batteries.

### Summary

The following is an overview of the subject matter described in detail herein. This summary is not intended to limit the protection scope of the claims.

In order to solve the above problems, the present disclosure provides a method for preparing a multi-element alloy compound capable of accurately controlling alloy composition and the prepared multi-element alloy compound, a method for preparing ink by adopting the multi-element alloy compound and the prepared multi-element alloy compound ink, as well as a method for preparing a film absorption layer by adopting the multi-element alloy compound ink and the prepared multi-element alloy compound film absorption layer.

An embodiment of the present disclosure provides a method for preparing a multi-element alloy compound, comprising the following steps: placing materials to be melted for preparing the multi-element alloy compound in a high-temperature synthesis zone of a vacuum container after being uniformly mixed, and placing materials to be sublimated for preparing the multi-element alloy compound in a low-temperature evaporation zone of the vacuum container; heating the materials to be melted in the high-temperature synthesis zone to a molten state to form a molten material; and heating the materials to be sublimated in the low-temperature evaporation zone to a gaseous state to allow the sublimated gaseous material to react with the molten material.

An embodiment of the present disclosure also provides a multi-element alloy compound prepared by the method for preparing the multi-element alloy compound as described above.

An embodiment of the present disclosure also provides a method for preparing a multi-element alloy compound ink which can accurately control the composition ratio of each component of the multi-element alloy compound.

The method for preparing the multi-element alloy compound ink provided by the embodiment of the present disclosure includes the following steps: grinding the multi-element alloy compound prepared by the method for preparing a multi-element alloy compound as described above into powder; adding a solvent, a binder and a dispersant into the powder and uniformly stirring to form a mixture; and removing the solvent in the mixture to obtain the multi-element alloy compound ink. An embodiment of the present disclosure also provides a multi-element alloy compound ink prepared by the method for preparing the multi-element alloy compound ink as described above.

An embodiment of the present disclosure also provides a method for preparing a multi-element alloy compound film absorption layer which can accurately control the composition ratio of the multi-element alloy compound.

The preparation method for preparing the multi-element alloy compound film absorption layer provided by the embodiment of the present disclosure includes the following steps: coating the multi-element alloy compound ink prepared by the method for preparing a multi-element alloy compound ink as described above on the surface of a substrate, drying the coated substrate and the ink, and annealing the dried substrate and the ink.

An embodiment of the present disclosure also provides a multi-element alloy compound film absorption layer prepared by the method for preparing a multi-element alloy compound film absorption layer as described above.

In the present disclosure, the term "multi-element alloy compound" is defined as a compound made of a plurality of elementary substances, in which the sublimation temperature of one elementary substance is lower than the melting temperature of a mixture composed of other elementary substances.

### Brief Description of Drawings

The accompanying drawings are used to provide a further understanding of the technical solution of the present disclosure and form a part of the specification, and together with the embodiments of the present disclosure, serve to explain the technical solution of the present disclosure and do not constitute a limitation on the technical solution of the present disclosure.
FIG. 1 is a schematic layout diagram of the preparation of a copper indium gallium selenium quaternary compound according to an embodiment of the present disclosure;
FIG. 2 is a schematic diagram after the first layer of ink is coated in an embodiment of the present disclosure;
FIG. 3 is a schematic diagram after the first layer of ink is dried in an embodiment of the present disclosure;
FIG. 4 is a schematic diagram after the second layer of ink is coated in an embodiment of the present disclosure; and
FIG. 5 is a schematic diagram of a film of a copper indium gallium selenium light absorption layer formed after annealing in an embodiment of the present disclosure.

### Detailed Description

The present disclosure will be further described below with reference to the drawings in the specification.

The following is only a preferred embodiment of the present disclosure, but the protection scope of the present disclosure is not limited thereto. Any changes or substitutions that can be easily thought of by those skilled in the art within the scope of technology disclosed in the present disclosure should be included within the protection scope of the present disclosure. Therefore, the protection scope of the present disclosure should be based on the protection scope defined in the claims.

An embodiment of the present disclosure provides a method for preparing a multi-element alloy compound, comprising the following steps:
placing materials to be melted for preparing the multi-element alloy compound in a high-temperature synthesis zone of a vacuum container after being uniformly mixed, and placing materials to be sublimated for preparing the multi-element alloy compound in a low-temperature evaporation zone of the vacuum container;
heating the materials to be melted in the high-temperature synthesis zone to a molten state to form a molten material; and
heating the materials to be sublimated in the low-temperature evaporation zone to a gaseous state to allow the sublimated gaseous material to react with the molten material.

In an exemplary embodiment, the method may further include: continuously maintaining a positive temperature gradient between the low-temperature evaporation zone and the high-temperature synthesis zone.

In an exemplary embodiment, the method may further include: controlling time when the materials to be sublimated in the low-temperature evaporation zone begin to change into a gaseous state is not earlier than time when the materials to be melted in the high-temperature synthesis zone are melted.

In an exemplary embodiment, the method may further include: holding temperature of the high-temperature synthesis zone and the low-temperature evaporation zone after both the high-temperature synthesis zone and the low-temperature evaporation zone are heated to respective setting temperatures so as to carry out continuous reaction of the sublimated gaseous material with the molten material; cooling the high-temperature synthesis zone and the low-temperature evaporation zone after the reaction is completed.

In an exemplary embodiment, the method may further include: lowering the temperature of the high-temperature synthesis zone to be not lower than melting temperature of the multi-element alloy compound formed in the high-temperature synthesis zone after the temperature of the high-temperature synthesis zone has been held for a set period of time, and holding the lowered temperature of the high-temperature synthesis zone to carry out the reaction; during the process of lowering the temperature of the high-temperature synthesis zone and holding the lowered temperature of the high-temperature synthesis zone, the temperature of the low-temperature evaporation zone is continuously held at the originally held temperature until the reaction is completed.

In the present disclosure, a vacuum container refers to a container that pumps the internal air pressure to 10⁻¹ pa to 10⁻⁴ pa during an operating state.

In an exemplary embodiment, the multi-element alloy compound may include a copper indium gallium selenium compound, materials to be melted for preparing the copper indium gallium selenium compound may include copper, indium, and gallium elementary substances, and materials to be sublimated for preparing the copper indium gallium selenium compound may include selenium elementary substance.

In an exemplary embodiment, the vacuum container may be an L-shaped quartz tube or a ceramic tube, two ends of the L-shaped quartz tube or ceramic tube may be the high-temperature synthesis zone and the low-temperature evaporation zone, respectively, the high-temperature synthesis zone may have a container configured to enable to contain the copper, indium and gallium elementary substances, and the low-temperature evaporation zone may have a container configured to enable to contain the selenium elementary substance.

In an exemplary embodiment, the container in the high-temperature synthesis zone and the container in the low-temperature evaporation zone may be quartz boats, crucibles, or pits formed in the high-temperature synthesis zone and the low-temperature evaporation zone.

In an exemplary embodiment, the method may include the following steps: uniformly mixing copper, indium and gallium elementary substances, then placing them in a container in a high-temperature synthesis zone, and placing the selenium elementary substance in a container in a low-temperature evaporation zone; and heating copper, indium and gallium in the high-temperature synthesis zone to a molten state, and heating selenium in the low-temperature evaporation zone to a gaseous state for reaction.

In an exemplary embodiment, the method may further include:
controlling that the time when the selenium elementary substance in the low-temperature evaporation zone begins to change into a gaseous state is not earlier than the time when copper, indium and gallium in the high-temperature synthesis zone are melted;
holding the temperature of the high-temperature synthesis zone and the low-temperature evaporation zone after both the high-temperature synthesis zone and the low-temperature evaporation zone are heated to the respective setting temperatures;
after the temperature of the high-temperature synthesis zone is holed for a set period of time, the temperature of the high-temperature synthesis zone is lowered to be not less than the melting temperature of the copper indium gallium selenium compound and then held again to carry out the reaction; during the process of cooling and holding the lowered temperature of the high-temperature synthesis zone in the high-temperature synthesis zone, the temperature of the low-temperature evaporation zone is held at the originally held temperature until the reaction is completed; cooling the high-temperature synthesis zone and the low-temperature evaporation zone to 100°C or less after the reaction is completed; and
continuously maintaining a positive temperature gradient between the low-temperature evaporation zone and the high-temperature synthesis zone.

In an exemplary embodiment, firstly copper, indium and gallium may be heated to a molten state, so that the copper, indium and gallium are reacted firstly, and then selenium is heated and sublimated into a gaseous state to form a selenium atmosphere in a vacuum container, thereby selenizing the copper, indium and gallium. In order to enable the copper, indium and gallium to be evenly selenized during the process of selenization, the time when the copper, indium and gallium are completely melted can be not later than the time when selenium begins to be sublimated. In addition, in order to ensure that selenium vapor can be transported to the high-temperature synthesis zone at a stable rate, there can always be a positive temperature gradient from the low-temperature evaporation zone to the high-temperature synthesis zone.

In an exemplary embodiment, the method may further include:
when the temperature of the high-temperature synthesis zone is elevated to 700°C-750°C, the temperature of the low-temperature evaporation zone starts to elevate, so as to control that the time when the selenium elementary substance in the low-temperature evaporation zone begins to change into a gaseous state is not earlier than the time when the copper, indium and gallium in the high-temperature synthesis zone are melted;
when the temperature of the high-temperature synthesis zone is elevated to 1100°C-1150°C, the temperature of the high-temperature synthesis zone starts to be held; after the temperature of the low-temperature evaporation zone is elevated to 550°C-600°C, the temperature of the low-temperature evaporation zone is held; and
after the temperature of the high-temperature synthesis zone is held at 1100°C-1150°C for a set period of time, the temperature of the high-temperature synthesis zone is lowered to 950°C-1000°C and then held again, and at the same time the temperature of the low-temperature evaporation zone is continuously held at 550°C-600°C until the reaction is completed; after the reaction is completed, the temperature of the high-temperature synthesis zone and the low-temperature evaporation zone is lowered to 100°C or less.

In an exemplary embodiment, the raw materials for preparing the copper indium gallium selenium compound may be: 10 mole parts of copper, 7-9 mole parts of indium, 1-3 mole parts of gallium, and more than 2 mole parts of selenium.

In an exemplary embodiment, the vacuum container may be a quartz tube or a ceramic tube.

In an exemplary embodiment, the vacuum container may be an L-shaped quartz tube or a ceramic tube.

In an exemplary embodiment, the two ends of the L-shaped quartz tube may be a high-temperature synthesis zone and a low-temperature evaporation zone, respectively, the high-temperature synthesis zone is provided with a container configured to contain copper, indium and selenium elementary substances, the low-temperature evaporation zone is provided with a container configured to contain selenium elementary substance, and the container may be a quartz boat, a crucible or a pit formed in the high-temperature synthesis zone or the low-temperature evaporation zone.

An embodiment of the present disclosure also provides a multi-element alloy compound prepared by the method for preparing a multi-element alloy compound as described above.

An embodiment of the present disclosure also provides a method for preparing a multi-element alloy compound ink which can accurately control the composition ratio of each component of the multi-element alloy compound.

The method for preparing a multi-element alloy compound ink provided by the embodiment of the present disclosure includes the following steps: preparing ink by adopting the multi-element alloy compound prepared by the method for preparing a multi-element alloy compound as described above.

In an exemplary embodiment, the method may include the following steps: grinding the multi-element alloy compound prepared by the method for preparing a multi-element alloy compound as described above into powder; adding a solvent, a binder and a dispersant into the powder and uniformly stirring to form a mixture; and removing the solvent in the mixture to obtain the multi-element alloy compound ink.

In an exemplary embodiment, removing the solvent in the mixture may be heating evaporation or standing evaporation.

Since the method for preparing a multi-element alloy compound can accurately control the content of each component in the multi-element alloy compound, the content of each component in the ink can also be accurately controlled if a multi-element alloy compound ink is prepared by adopting the multi-element alloy compound prepared by the method for preparing a multi-element alloy compound as described above.

In an exemplary embodiment, the solvent may be selected from any one or two of ethanol and methanol, the dispersant may be selected from any one or two of terpineol and tert-butanol, and the binder may be selected from any one or more of ethyl cellulose and cellulose derivatives.

In an exemplary embodiment, the cellulose derivative may be a cellulose ester derivative.

In an exemplary embodiment, the heating evaporation process may be performed using a rotary evaporator.

An embodiment of the present disclosure also provides a multi-element alloy compound ink prepared by the method for preparing a multi-element alloy compound ink as described above.

An embodiment of the present disclosure provides a method for preparing a multi-element alloy compound film absorption layer capable of accurately controlling the composition ratio of multi-element alloy compound.

The method for preparing a multi-element alloy compound film absorption layer provided by the embodiment of the present disclosure includes the following steps: preparing the multi-element alloy compound film absorption layer by adopting the multi-element alloy compound ink prepared by the method for preparing a multi-element alloy compound ink as described above.

In an exemplary embodiment, the method may include the following steps: coating the multi-element alloy compound ink prepared by the method for preparing a multi-element alloy compound ink as described above on the surface of a substrate, drying the coated substrate and the ink, and annealing the dried substrate and the ink.

When the method for preparing a multi-element alloy compound film absorption layer of the present disclosure is used to prepare a copper indium gallium selenium film absorption layer, the low film forming annealing temperature and good crystallization are achieved, without extra selenization.

Since the composition ratio of each component of the multi-element alloy compound in the ink as described above can be accurately controlled, the composition ratio of each component can also be accurately controlled in the preparation process of the multi-element alloy compound film absorption layer by adopting the printing method in the present disclosure, thus overcoming the defect that the composition ratio is difficult to be controlled in the preparation process of the multi-element alloy compound film absorption layer by adopting the printing method in the past.

When the multi-element alloy compound film absorption layer is a copper indium gallium selenium film absorption layer, the method for preparing the multi-element alloy compound film absorption layer of the present disclosure may include the following steps:
coating at least two layers of the copper indium gallium selenium ink prepared by the method for preparing a multi-element alloy compound ink as described above on the surface of a substrate, so that the content ratio of indium to gallium of one layer of ink which is close to the sunny side and belongs to the two adjacent layers of ink is lower than the content ratio of indium to gallium of one layer of ink far away from the sunny side;
drying each layer of ink after being coated; and
annealing each layer of ink after drying the last layer of ink.

In an exemplary embodiment, the process of coating ink on the surface of the substrate may include the following steps:
coating a layer of ink on the substrate and drying;
coating another layer of ink on the previous layer of ink and drying; and annealing the substrate and each layer of ink after each layer of ink is coated.

In the above steps, the step of coating another layer of ink on the previous layer of ink and drying is performed at least once.

An embodiment of the present disclosure also provides a multi-element alloy compound film absorption layer prepared by the method for preparing a multi-element alloy compound film absorption layer as described above.

Since the content of each component in the multi-element alloy compound is controllable, multi-element alloy compounds with different band gap widths can be prepared. The multi-element alloy compound film absorption layer with progressive band gap can be prepared by adopting multi-element alloy compound with different band gap widths, thus realizing the purpose of preparing a multi-element alloy compound film absorption layer with progressive band gap by a printing method.

An embodiment of the present disclosure provides a method for preparing a multi-element alloy compound, taking the preparation of a copper indium gallium selenium compound as an example, the method may include the following steps:
S1: providing a vacuum container comprising a high-temperature synthesis zone 1 and a low-temperature evaporation zone 2 which are arranged at intervals;
S2: placing copper, indium and gallium elementary substances in the high-temperature synthesis zone 1, and placing selenium elementary substance in the low-temperature evaporation zone 2;
S3: heating the copper, indium and gallium elementary substances in the high-temperature synthesis zone 1 to a molten state, and heating the selenium elementary substance in the low-temperature evaporation zone 2 to a gaseous state; the time when selenium in the low-temperature evaporation zone 2 begins to change into a gaseous state is not earlier than the time when the copper, indium and gallium are melted;
S4: holding the temperature of the high-temperature synthesis zone 1 and the low-temperature evaporation zone 2;
S5: lowering the temperature of the high-temperature synthesis zone 1 to be not lower than the melting temperature of the copper indium gallium selenium alloy and holding the temperature of the high-temperature synthesis zone 1 again, and then lowering the temperature of the high-temperature synthesis zone 1 and the low-temperature evaporation zone 2 to 100°C or less.

In the above steps, it is possible to continuously maintain a positive temperature gradient between the low-temperature evaporation zone 2 and the high-temperature synthesis zone 1, i.e., the temperature of the vacuum container is elevated in gradient from the low-temperature evaporation zone 2 to the high-temperature synthesis zone 1.

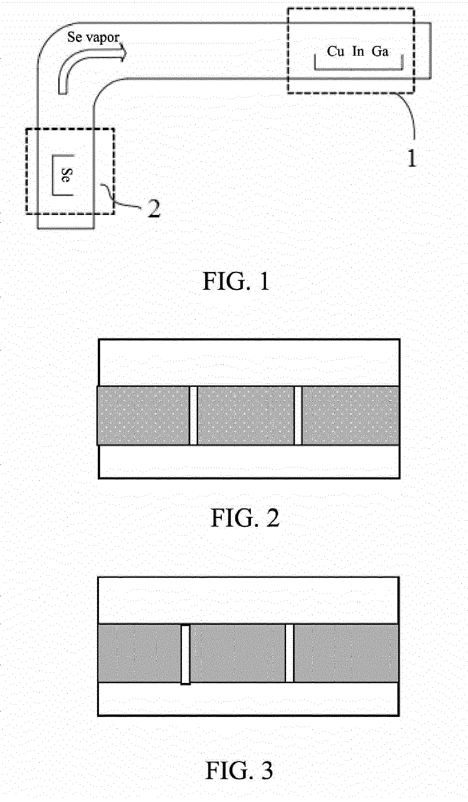

In step S1, a vacuum container is provided, which may be a container made of a high temperature resistant material such as a quartz tube or a ceramic tube and having a certain rigidity. As shown in FIG. 1, the parts with certain intervals in the vacuum container can be used as the high-temperature synthesis zone 1 and the low-temperature evaporation zone 2, respectively. When the materials are placed into the above container, the air pressure in the container is pumped to 10⁻¹ pa or less to become a vacuum container. In step S2, Cu, In, Ga and Se elementary substances with the purity of more than 99.999 % may be used as raw materials, and the mass of each elementary substance may be weighed and formulated according to the composition CuIn_{0.7}Ga_{0.3}Se_{2.05}, i.e. elementary substances are weighed according to 1 mole part of Cu, 0.7 mole part of In, 0.3 mole part of Ga, and 2.05 mole parts of Se. Se elementary substance may be placed in a quartz boat at one end of the short side of the L-shaped quartz tube, Cu, In and Ga elementary substances may be placed in a quartz boat at one end of the long side of the L-shaped quartz tube. The quartz tube may be vacuumized to 10⁻² pa or less and then sealed and placed in an electric heating furnace. The quartz boat containing the Se elementary substance may correspond to the low-temperature zone corresponding to the low-temperature evaporation zone 2 in the electric heating furnace. The quartz boat containing the Cu, In and Ga elementary substances may correspond to the high-temperature zone corresponding to the high-temperature synthesis zone 1 in the electric heating furnace. In addition to the L-shaped quartz tube, the reactor described above can also be used to form a vacuum container, and the reactor can be evacuated to other pressures of 10⁻¹ pa or less, for example, 10⁻¹pa, 10⁻²pa, 10⁻³pa or 10⁻⁴pa. It is also possible to use other high temperature resistant containers instead of quartz boat, for example, crucible, to hold the materials. If there are pits in the high-temperature synthesis zone 1 and the low-temperature evaporation zone 2 of the container, the materials can be directly placed in the pits. In addition to the electric heating furnace, other heating devices can also be used to heat the L-shaped quartz tube. The method for preparing a multi-element alloy compound of this embodiment can be carried out in a device including a vacuum container and heating devices, the vacuum container includes a high-temperature synthesis zone 1, a low-temperature evaporation zone 2, and a sealing device; the high-temperature synthesis zone 1 and the low-temperature evaporation zone 2 are respectively arranged at the two ends of the vacuum container; the heating devices are arranged around the vacuum container at intervals and are configured to heat the vacuum container and form a temperature gradient; the vacuum container has an opening, and the sealing device is configured to be able to seal the opening.

The high-temperature synthesis zone 1 and the low-temperature evaporation zone 2 are respectively arranged at the two ends of the vacuum container, so that the high-temperature synthesis zone 1 and the low-temperature evaporation zone 2 are separated by a set distance, and can be heated to different temperatures. Under the condition that the distance requirement is met, the positions of the high-temperature synthesis zone 1 and the low-temperature evaporation zone 2 can be adjusted as required.

The heating devices may be configured to be able to heat different zones of the vacuum container so that the temperature of each zone can be individually controlled and a temperature gradient can be formed.

The heating device may be electric heating coils that surround the outer surface of the vacuum container or may be arranged at a position close to the outer surface of the vacuum container.

The compositions of the copper indium gallium selenium compound described above are not limited to the compositions of the copper indium gallium selenium compound prepared in this embodiment. For example, the copper indium gallium selenium compounds of the following composition may also be prepared: CuIn_{0.85}Ga_{0.15}Se_{2.05}, CuIn_{0.9}Ga_{0.1}Se₂, CuIn_{0.8}Ga_{0.2}Se₂, CuIn_{0.75}Ga_{0.25}Se₂. In the preparation process of the above copper indium gallium selenium compounds, the mass of copper, indium and gallium elementary substances may be calculated according to that the sum of the mole parts of indium and gallium is substantially equal to the mole parts of copper during weighing. For example, the mole part ratio of copper, indium and gallium can be substantially equal to the atomic number ratio of copper, indium and gallium in the compound to be prepared, while the mole part of selenium can be calculated to be greater than twice the mole part of copper. For example, the mole part ratio of selenium to copper can be slightly larger than the atomic number ratio of selenium to copper in the compound to be prepared. For example, the mole part of selenium may be 2.1 times, 2.2 times, 2.3 times, 2.4 times or 2.5 times that of copper. Excess selenium may be placed in the low-temperature evaporation zone 2, so that during the whole reaction process, since selenium is excessive, the reaction can continuously be carried out in an atmosphere of selenium vapor.

In step S3, a temperature gradient range from low temperature to high temperature may be formed by adjusting the temperature control power between the high-temperature synthesis zone and the low-temperature evaporation zone, for example, a linear temperature gradient range can be formed. The high-temperature synthesis zone 1 can be set to elevate the temperature to 1100-1150°C for 85 min to 90 min. When the high-temperature synthesis zone 1 starts to be heated up for 55 min to 60 min, the temperature of the high-temperature synthesis zone 1 can be elevated to 700°C-750°C. At this time, the heating up of the low-temperature evaporation zone 2 can start, and the heating up of the low-temperature evaporation zone 2 to 550°C-600°C can be set for 55 min to 60 min. For example, the heating power of the heating devices corresponding to the respective zones between the high-temperature synthesis zone 1 and the low-temperature evaporation zone 2 can be individually adjusted so that a temperature gradient range from low temperature to high temperature can be formed from the low-temperature evaporation zone 2 to the high-temperature synthesis zone 1. The zone between the low-temperature evaporation zone 2 and the high-temperature synthesis zone 1 may be heated so that the zone from the low-temperature evaporation zone 2 to the high-temperature synthesis zone 1 forms a temperature gradient zone from low temperature to high temperature.

The fact that the time when selenium in the low-temperature evaporation zone 2 begins to change into the gaseous state is not earlier than the time when copper, indium and gallium are melted, may be that the time when selenium in the low-temperature evaporation zone 2 begins to change into the gaseous state is not earlier than the time when copper, indium and gallium are completely melted.

In step S4, the temperature is held after the high-temperature synthesis zone 1 and the low-temperature evaporation zone 2 reach the respective maximum setting temperatures. The time for holding temperature can be calculated according to the quantity of materials, reaction type and other conditions, so as to ensure that the copper, indium, gallium and selenium can be completely reacted. For example, the temperature of both the high-temperature synthesis zone 1 and the low-temperature evaporation zone 2 are held for 6h after both the high-temperature synthesis zone 1 and the low-temperature evaporation zone 2 reach the maximum temperature. The high-temperature synthesis zone 1 and the low-temperature evaporation zone 2 can reach the respective maximum temperatures at the same time by controlling the heating rates of the high-temperature synthesis zone 1 and the low-temperature evaporation zone 2, and then holding temperature can start at the same time.

In step S5, the temperature of the high-temperature synthesis zone 1 is lowered to be not lower than the melting temperature of the copper indium gallium selenium alloy and then holed, which is beneficial to avoiding that selenium volatilization is greater than selenium incorporation due to excessive temperature in the later stage of the reaction process, thus is beneficial to the good formation of compounds. The temperature of the high-temperature synthesis zone 1 may be set to lower to 950°C-1000°C for 15 min, and then hold for 1.5h to 2h. When the temperature of the high-temperature synthesis zone 1 is held at 950°C to 1000°C, the temperature of the low-temperature evaporation zone 2 may be continuously held at 700°C to 750°C, and then all heating devices are turned off to cool the high-temperature synthesis zone 1 and the low-temperature evaporation zone 2 to 100°C or less with the electric heating furnace. A CIGS quaternary compound is obtained in the quartz boat of the high-temperature synthesis zone 1, and the composition of the synthesized CIGS compound is CuIn_{0.7}Ga_{0.3}Se₂. In this embodiment, the mass of each elementary substance is weighed and formulated according to the composition CuIn_{0.7}Ga_{0.3}Se_{2.05} in step S2, and the composition of the obtained CIGS compound is CuIn_{0.7}Ga_{0.3}Se₂, that is, to obtain the compound CuIn_{0.7}Ga_{0.3}Se₂, the molar ratio of elementary substances to be weighed can be calculated according to the atomic ratio of elements in CuIn_{0.7}Ga_{0.3}Se_{2.05}.

In order to ensure that selenium vapor does not condense on the inner wall of the quartz tube during transportation, there may be a positive temperature gradient between the low-temperature evaporation zone 2 and the high-temperature synthesis zone 1. In order to ensure the stability of vapor transportation rate, it may be controlled that there is a linear temperature gradient between the low-temperature evaporation zone 2 and the high-temperature synthesis zone 1 of the quartz tube.

In the preparation method of the copper indium gallium selenium compound of this embodiment, firstly copper, indium and gallium are heated to a molten state, so that the copper, indium and gallium are reacted firstly, and then selenium is heated and sublimated into a gaseous state to form a selenium atmosphere in a vacuum container, thereby selenizing the copper, indium and gallium. In order to enable the copper, indium and gallium to be evenly selenized, the present disclosure can ensure that the time when the copper, indium and gallium are completely melted is not later than the time when selenium begins to be sublimated. In addition, in order to ensure that selenium vapor can be transported to the high-temperature synthesis zone 1 at a stable rate, there may always be a positive temperature gradient from the low-temperature evaporation zone 2 to the high-temperature synthesis zone 1.

In addition to the copper indium gallium selenium compound, the method for preparing a multi-element alloy compound of this embodiment may also be used for preparing other multi-element alloy compounds.

An embodiment of the present disclosure provides a method for preparing CIGS ink, which may include the following steps:
S10: grinding the prepared copper indium gallium selenium compound into powder;
S20: adding a solvent, a binder and a dispersant into the powder and uniformly stirring to form a mixture;
S30: removing the solvent by subjecting the mixture to heating evaporation or standing volatilization to form CIGS ink.

In step S10, the prepared CIGS compound may be ground into nanopowder using a zirconia planetary ball mill, but the method of crushing the CIGS compound is not limited to zirconia planetary ball mill, and other methods may also be used as long as CIGS can be crushed into nanopowder.

In step S20, the copper indium gallium selenium compound powder may be mixed with a solvent, a binder, and a dispersant to form a mixture; the resulting mixture is ultrasonically stirred to form a uniform mixture. The solvent may be ethanol, methanol or a mixture thereof; the binder may be ethyl cellulose, cellulose derivatives (e.g., cellulose ester derivatives) or a mixture thereof; the dispersant may be terpineol, tert-butanol or a mixture thereof.

In step S30, anhydrous ethanol or other solvents in the mixture formed in step S20 may be evaporated by a rotary evaporator to obtain CIGS ink. In the ultrasonic stirring process, ethyl cellulose, cellulose derivatives or a mixture thereof may be dissolved in terpineol, tert-butanol or a mixture thereof to form a liquid adhesive phase, and anhydrous ethanol may be used to adjust the viscosity of the bonding phase to a suitable range, so as to facilitate the uniform distribution of the copper indium gallium selenium alloy; after the distribution is completed, the anhydrous ethanol therein is evaporated, and finally the powder of the copper indium gallium selenium alloy is uniformly suspended in the resulting liquid substance to form the copper indium gallium selenium ink.

The method of evaporating anhydrous ethanol may be carried out by using a rotary evaporator, which does not limit the method of evaporating ethyl alcohol in the present disclosure. For example, anhydrous ethanol may also be removed by the method of depressurizing evaporation or by heating the mixture, or even the mixture may be placed at room temperature until anhydrous ethanol is evaporated naturally.

An embodiment of the present disclosure provides a method for preparing a copper indium gallium selenium film absorption layer, which may include the following steps: coating the prepared copper indium gallium selenium ink on a Mo-plated soda lime glass or stainless steel substrate by screen printing, in which the coating may be intermittent coating or continuous coating according to the overall process requirements of the film battery; transferring the substrate coated with ink into a continuous sintering furnace for drying and annealing the slurry, in which the drying temperature may be between 150°C and 250°C, the drying time may be between 3 min and 5 min, the annealing temperature may be between 450°C and 550°C, the annealing time may be between 10 min and 15 min; and finally obtaining a CIGS film absorption layer.

In this embodiment, the prepared ink may be coated on a Mo-plated soda lime glass or stainless steel substrate, and then the ink is dried. During the drying process, the liquid adhesive phase can be evaporated or decomposed, while the copper indium gallium selenium powder will be left on the substrate, and then the copper indium gallium selenium powder is annealed. During the annealing process, the copper indium gallium selenium powder will grow to form a film absorption layer of copper indium gallium selenium. Since copper indium gallium selenium alloy is used in the preparation of the ink, it is not necessary to heat it to the reaction temperature of copper indium gallium selenium during the annealing process, but only to heat it to the annealing temperature to grow the powder into a film.

Since the method for preparing a copper indium gallium selenium alloy in the present disclosure can accurately control the composition of the copper indium gallium selenium alloy, the composition of the film absorption layer can also be controlled if the prepared copper indium gallium selenium alloy is used to prepare the film absorption layer in the method for preparing a copper indium gallium selenium film absorption layer in this embodiment, thereby controlling the band gap width of the film absorption layer.

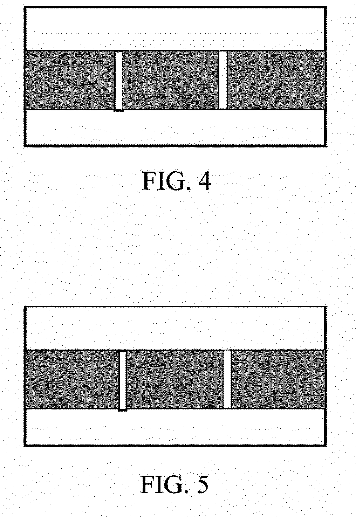

An embodiment of the present disclosure provides a method for preparing a copper indium gallium selenium film absorption layer. The method may include the following steps: firsly coating ink I on a Mo-plated soda lime glass or stainless steel substrate by screen printing, in which the coating may be intermittent coating or continuous coating according to the overall process requirements of the film battery, intermittent coating is as shown in FIG. 2 after the coating is completed; transferring the substrate coated with ink I into a sintering furnace for drying the slurry, in which the drying temperature may be 150°C to 250°C, and the drying time may be 2 min to 3 min, as shown in FIG. 3; selecting ink II to carry out a secondary printing on the substrate to which the dried ink I is attached, as shown in FIG. 4, in which the coating may be intermittent coating or continuous coating according to the overall process requirements of the film battery; transferring the substrate coated with ink II into a continuous sintering furnace for drying and annealing the ink, in which the drying temperature may be 150°C to 250°C, the drying time may be 3 min to 5 min, the annealing temperature may be 450°C to 550°C, and the annealing time may be 10 min to 15 min, and finally obtaining a CIGS film absorption layer with double band gaps, as shown in FIG. 5.

In this embodiment, ink I and ink II are inks prepared from the prepared copper indium gallium selenium alloy with different compositions. For example, ink I may be ink prepared from the prepared CuIn_{0.7}Ga_{0.3}Se₂, and ink II may be ink prepared from the prepared Culn_{0.85}Ga_{0.15}Se_{2.05}.

The ink used in the film absorption layer is not limited to the selection of the ink of this embodiment, and the number of printing times of the ink cannot be limited to the number of printing times of the ink of the present disclosure.

For example, inks prepared from copper indium gallium selenium with the compositions such as CuIn_{0.9}Ga_{0.1}Se₂, CuIn_{0.8}Ga_{0.2}Se₂, CuIn_{0.75}Ga_{0.25}Se₂ may also be used to print for three or more times. However, during the printing process, the content ratio of indium to gallium of one layer of ink which is close to the sunny side and belongs to the two adjacent layers of ink can be lower than that of one layer of ink far away from the sunny side, which can ensure that the band gap of the light absorption layer of the progressive band gap gradually narrows from the sunny side to the back side, thus, the long-wavelength light can be absorbed by the latter absorption layer through the previous absorption layer, so that the light of each wavelength is absorbed layer by layer by the absorption layers arranged from the sunny side to the back side, thereby improving the light absorption rate.

In an embodiment of the present disclosure, a copper indium gallium selenium compound is firstly prepared, and the steps are as follows:
S1: providing a vacuum container comprising a high-temperature synthesis zone 1 and a low-temperature evaporation zone 2 which are arranged at intervals;
S2: placing copper, indium and gallium elementary substances in the high-temperature synthesis zone 1, and placing selenium elementary substance in the low-temperature evaporation zone 2;
S3: heating copper, indium and gallium elementary substances in the high-temperature synthesis zone 1 to a molten state, and heating selenium in the low-temperature evaporation zone 2 to a gaseous state; the time when the selenium in the low-temperature evaporation zone 2 begins to change into a gaseous state being not earlier than the time when the copper, indium and gallium are melted;
S4: holding the temperature of the high-temperature synthesis zone 1 and the low-temperature evaporation zone 2;
S5: lowering the temperature of the high-temperature synthesis zone 1 to be not lower than the melting temperature of the copper indium gallium selenium alloy and holding the temperature, and then lowering the temperature of the high-temperature synthesis zone 1 and the low-temperature evaporation zone 2 to 100°C or less.

In the above steps, it is possible to continuously maintain a positive temperature gradient between the low-temperature evaporation zone 2 and the high-temperature synthesis zone 1.

In step S1, a vacuum container is provided, which may be an L-shaped quartz tube. The vacuum container includes a high-temperature synthesis zone and a low-temperature evaporation zone, and parts with certain intervals in the vacuum container can be respectively used as a high-temperature synthesis zone 1 and a low-temperature evaporation zone 2. The two ends of the L-shaped quartz tube can be respectively a high-temperature synthesis zone and a low-temperature evaporation zone, the high-temperature synthesis zone is provided with a quartz boat containing copper, indium and selenium elementary substances, and the low-temperature evaporation zone is provided with a quartz boat containing selenium elementary substance.

In step S2, Cu, In, Ga and Se elementary substances with the purity of more than 99.999 % may be used as raw materials, and the mass of each elementary substance may be weighed and formulated according to the composition CuIn_{0.8}Ga_{0.2}Se_{2.05}, i.e. elementary substances are weighed according to 1 mole part of Cu, 0.8 mole part of In, 0.2 mole part of Ga, and 2.05 mole parts of Se. Se Elementary substance may be placed in a quartz boat at one end of the short side of the L-shaped quartz tube, and Cu, In and Ga elementary substances may be placed in a quartz boat at one end of the long side of the L-shaped quartz tube. The quartz tube is vacuumized to 10⁻³ pa or less and then sealed and placed in an electric heating furnace. The quartz boat containing the Se elementary substance corresponds to the low-temperature zone corresponding to the low-temperature evaporation zone 2 in the electric heating furnace, and the quartz boat containing the Cu, In and Ga elementary substances corresponds to the high-temperature zone corresponding to the high-temperature synthesis zone 1 in the electric heating furnace.

In step S3, a linear temperature gradient range from low temperature to high temperature may be formed by adjusting the temperature control power between the high-temperature synthesis zone and the low-temperature evaporation zone. The high-temperature synthesis zone 1 may be set to heat up to 1125°C for 88 min. When the high-temperature synthesis zone 1 starts to heat up for 55 min, the temperature of the high-temperature synthesis zone 1 may be elevated to 725°C. At this time, the temperature of the low-temperature evaporation zone 2 may be set to elevate to 575°C for 56 min.

In step S4, the temperature of the high-temperature synthesis zone and the temperature of the low-temperature evaporation zone may be held for 6 h respectively after the high-temperature synthesis zone 1 reaches 1125°C and the low-temperature evaporation zone 2 reaches 575°C.

In step S5, the temperature of the high-temperature synthesis zone may be set to lower to 960°C for 15 min, then hold for 2 h again. When the high-temperature synthesis zone 1 is held at 960°C, the low-temperature evaporation zone 2 can be held at 575°C continuously, and then all heating devices are turned off to cool the high-temperature synthesis zone 1 and the low-temperature evaporation zone 2 to 100°C or less with the electric heating furnace. A CIGS quaternary compound is obtained in the quartz boat of the high-temperature synthesis zone 1, and the composition of the synthesized CIGS compound is CuIn_{0.8}Ga_{0.2}Se₂.

In order to ensure that selenium vapor does not condense on the inner wall of the quartz tube during the transportation, there may be a positive temperature gradient between the low-temperature evaporation zone 2 and the high-temperature synthesis zone 1. In order to ensure the stability of vapor transportation rate, it may be controlled that there is a linear temperature gradient between the low-temperature evaporation zone 2 and the high-temperature synthesis zone 1 of the quartz tube.

Next, the CIGS quaternary compound is used to prepare CIGS ink, which may include the following steps:
S10: grinding the prepared CIGS compound into nanopowder using a zirconia planetary ball mill.
S20: mixing CIGS compound powder with a solvent, a binder and a dispersant; ultrasonically stirring the resulting mixture to form a uniform mixture, in which the solvent may be anhydrous ethanol; the binder may be ethyl cellulose; the dispersant may be terpineol.
S30: anhydrous ethanol in the mixture may be evaporated by a rotary evaporator to obtain CIGS ink, in which during the ultrasonic stirring process, ethyl cellulose may be dissolved in terpineol to form a liquid adhesive phase, and anhydrous ethanol may be used to adjust the viscosity of the adhesive phase to a suitable range, so as to facilitate the uniform distribution of the copper indium gallium selenium alloy, after the distribution is completed, the anhydrous ethanol in the copper indium gallium selenium alloy is evaporated, and finally the copper indium gallium selenium alloy powder is uniformly suspended in the liquid substance to form a copper indium gallium selenium ink.

The method for preparing a copper indium gallium selenium light absorption layer by using the copper indium gallium selenium ink prepared above may include the following steps: coating the prepared copper indium gallium selenium ink on a Mo-plated soda lime glass or stainless steel substrate by screen printing, in which the coating may be intermittent coating or continuous coating according to the overall process requirements of the film battery; transferring the substrate coated with ink into a continuous sintering furnace for drying and annealing the slurry, in which the drying temperature may be 180°C, the drying time may be 4 min, the annealing temperature may be 500°C, and the annealing time may be 13 min, thus finally obtaining a CIGS film absorption layer.

Another method for preparing a copper indium gallium selenium light absorption layer by using the above copper indium gallium selenium ink may include the following steps: firstly coating ink I on a Mo-plated soda lime glass or stainless steel substrate by screen printing, in which the coating may be intermittent coating or continuous coating according to the overall process requirements of the film battery; transferring the substrate coated with ink I into a sintering furnace for drying the slurry, in which the drying temperature may be 160°C, and the drying time may be 3 min; selecting Ink II to carry out a secondary printing on the substrate to which the dried ink I is attached, in which the coating may be intermittent coating or continuous coating according to the overall process requirements of the film battery; transferring the substrate coated with ink II into a continuous sintering furnace for drying and annealing the ink, in which the drying temperature may be 200°C, the drying time may be 4 min, the annealing temperature may be 525°C, and the annealing time may be 13 min, and finally obtaining a CIGS film absorption layer with double band gaps.

Ink I and ink II may be inks prepared from the copper indium gallium selenium alloy with different compositions prepared in this embodiment according to the method for preparing CIGS ink in this embodiment.

Since the method for preparing a copper indium gallium selenium alloy in this embodiment can accurately control the composition of the copper indium gallium selenium alloy, when preparing a light absorption layer with progressive band gap, the composition of copper indium gallium selenium of each absorption layer can be controlled, and the band gap width of each absorption layer can also be controlled, thus enabling the printing method to prepare the light absorption layer with gradual band gap to be realized.

This disclosure is illustrative of the principles of examples of the present disclosure and is not intended to limit the present disclosure in any form or substance, or to limit the present disclosure to particular embodiments. It will be apparent to those skilled in the art that variations, changes, modifications, evolutions, and the like may be made to the elements, methods, and systems of the technical solutions of the examples of the present disclosure without departing from the principles, spirit, and scope of the examples, technical solutions of the present disclosure. Embodiments of such variations, changes, modifications, and evolutions are all included within equivalent examples of the present disclosure. Although the examples of the present disclosure may be embodied in many different forms, what is described in detail herein are merely some embodiments of the invention. Furthermore, examples of the present disclosure include any possible combination of some or all of the various embodiments described herein. All patents, patent applications, and other cited materials mentioned in the present disclosure or anywhere in any cited patent, cited patent application, or other cited material are hereby incorporated by reference in their entirety.

The above disclosure is intended to be illustrative and not exhaustive. Many variations and alternatives will be suggested to those skilled in the art. The term "include" means "include, but not limited to". A description of alternative embodiments of the present disclosure has been completed herein. Those skilled in the art will recognize other equivalent changes to the embodiments described herein.

## Claims

1. A method for preparing a multi-element alloy compound, **characterized by**:
placing materials to be melted for preparing the multi-element alloy compound in a high-temperature synthesis zone of a vacuum container after being uniformly mixed, and placing materials to be sublimated for preparing the multi-element alloy compound in a low-temperature evaporation zone of the vacuum container;
heating the materials to be melted in the high-temperature synthesis zone to a molten state to form a molten material; and
heating the material to be sublimated in the low-temperature evaporation zone to a gaseous state to allow the sublimated gaseous material to react with the molten material.

2. The method according to claim 1, further comprising: continuously maintaining a positive temperature gradient between the low-temperature evaporation zone and the high-temperature synthesis zone.

3. The method according to claim 2, further comprising: controlling that time when the materials to be sublimated in the low-temperature evaporation zone begin to change into a gaseous state is not earlier than time when the materials to be melted in the high-temperature synthesis zone are melted.

4. The method according to claim 3, further comprising: holding temperature of the high-temperature synthesis zone and the low-temperature evaporation zone after both the high-temperature synthesis zone and the low-temperature evaporation zone are heated to respective setting temperatures so as to carry out continuous reaction of the sublimated gaseous material with the molten material; cooling the high-temperature synthesis zone and the low-temperature evaporation zone after the reaction is completed.

5. The method according to claim 4, further comprising: lowering the temperature of the high-temperature synthesis zone to be not lower than melting temperature of the multi-element alloy compound formed in the high-temperature synthesis zone after the temperature of the high-temperature synthesis zone has been held for a set period of time, and holding the lowered temperature of the high-temperature synthesis zone to carry out the reaction; during the process of lowering the temperature of the high-temperature synthesis zone and holding the lowered temperature of the high-temperature synthesis zone, the temperature of the low-temperature evaporation zone is continuously held at the originally held temperature until the reaction is completed.

6. The method according to any one of claims 1-5, wherein the multi-element alloy compound comprises a copper indium gallium selenium compound, the materials to be melted for preparing the copper indium gallium selenium compound comprise copper, indium, and gallium elementary substances, and the materials to be sublimated for preparing the copper indium gallium selenium compound comprise selenium elementary substance.

7. The method according to claim 6, wherein the vacuum container is an L-shaped quartz tube or a ceramic tube, two ends of the L-shaped quartz tube or ceramic tube are the high-temperature synthesis zone and the low-temperature evaporation zone, respectively, the high-temperature synthesis zone is provided with a container configured to contain the copper, indium and gallium elementary substances, and the low-temperature evaporation zone is provided with a container configured to contain the selenium elementary substance; and
the container in the high-temperature synthesis zone and the container in the low-temperature evaporation zone are quartz boats, crucibles, or pits formed in the high-temperature synthesis zone and the low-temperature evaporation zone.

8. The method according to any one of claims 5-7, **characterized by**:
the temperature of the high-temperature synthesis zone is 1100°C-1150°C,
the lowered temperature of the high-temperature synthesis zone is 950°C-1000°C,
the temperature of the low-temperature evaporation zone is 550°C-600°C.

9. The method according to claim 6, wherein raw materials for preparing the copper indium gallium selenium compound are: 10 mole parts of copper, 7-9 mole parts of indium, 1-3 mole parts of gallium, and more than 2 mole parts of selenium.

10. A method for preparing a multi-element alloy compound ink, **characterized by**:
placing materials to be melted for preparing the multi-element alloy compound in a high-temperature synthesis zone of a vacuum container after being uniformly mixed, and placing materials to be sublimated for preparing the multi-element alloy compound in a low-temperature evaporation zone of the vacuum container;
heating the materials to be melted in the high-temperature synthesis zone to a molten state to form a molten material;
heating the material to be sublimated in the low-temperature evaporation zone to a gaseous state to allow the sublimated gaseous material to react with the molten material;
grinding the multi-element alloy compound into powder;
adding a solvent, a binder and a dispersant into the powder and uniformly stirring to form a mixture; and
removing the solvent in the mixture to obtain the multi-element alloy compound ink.

11. The method according to claim 10, wherein the solvent is selected from any one or two of ethanol and methanol, the dispersant is selected from any one or two of terpineol and tert-butanol, and the binder is selected from any one or more of ethyl cellulose and cellulose derivatives.

12. A method for preparing a multi-element alloy compound film absorption layer, **characterized by**:
placing materials to be melted for preparing the multi-element alloy compound in a high-temperature synthesis zone of a vacuum container after being uniformly mixed, and placing materials to be sublimated for preparing the multi-element alloy compound in a low-temperature evaporation zone of the vacuum container;
heating the materials to be melted in the high-temperature synthesis zone to a molten state to form a molten material;
heating the material to be sublimated in the low-temperature evaporation zone to a gaseous state to allow the sublimated gaseous material to react with the molten material;
grinding the multi-element alloy compound into powder;
adding a solvent, a binder and a dispersant into the powder and uniformly stirring to form a mixture;
removing the solvent in the mixture to obtain the multi-element alloy compound ink;
coating the ink on a surface of a substrate;
drying the coated substrate and the ink; and
annealing the dried substrate and the ink.

13. The method according to claim 12, wherein when the multi-element alloy compound film absorption layer is a copper indium gallium selenium film absorption layer, the method comprises the following steps:
coating at least two layers of ink on the surface of the substrate, wherein the content ratio of indium to gallium of one layer of ink which is close to the sunny side and belongs to the two adjacent layers of ink is lower than the content ratio of the indium to gallium of one layer of ink far away from the sunny side;
drying each layer of ink after being coated; and
annealing each layer of ink after drying the last layer of ink.

14. The method according to claim 13, wherein temperature of the drying is 150°C to 250°C, time of the drying is 3 min to 5 min, temperature of the annealing is 450°C to 550°C, and time of the annealing is 10 min to 15 min.

15. A multielement alloy compound prepared by the method according to any one of claims 1- 9.
